# EUROPÄISCHE PATENTSCHRIFT

(11) **EP 3 317 747 B1**
(45) Veröffentlichungstag und Bekanntmachung des Hinweises auf die Patenterteilung: **03.04.2019**
(21) Anmeldenummer: 16720719.0
(22) Anmeldetag: 29.04.2016
(51) Int. Cl.: G06F 3/01, B60K 37/06, H03K 17/96

(54) **KRAFTFAHRZEUG-BEDIENVORRICHTUNG MIT HAPTISCHER RÜCKMELDUNG**
AUTOMOTIVE OPERATING DEVICE WITH HAPTIC FEEDBACK
DISPOSITIF D'ACTIONNEMENT DE VÉHICULE AUTOMOBILE À RÉTROACTION HAPTIQUE

(30) Priorität: 02.07.2015 DE 102015008537
(43) Veröffentlichungstag der Anmeldung: 09.05.2018
(73) Patentinhaber: Audi AG, 85045 Ingolstadt (DE)
(72) Erfinder: WACHINGER, Michael, 86571 Winkelhausen (DE)
(86) Internationale Anmeldenummer: PCT/EP2016/000703
(87) Internationale Veröffentlichungsnummer: WO 2017/001033

(56) Entgegenhaltungen:
- EP-A1- 1 450 247
- EP-A2- 0 518 648
- DE-A1-102013 016 491
- US-A- 5 790 108

## Beschreibung

Die Erfindung betrifft eine Bedienvorrichtung für ein Kraftfahrzeug, mittels welcher zumindest ein Gerät des Kraftfahrzeugs durch einen Benutzer bedient werden kann. Die Bedienvorrichtung weist hierzu ein Betätigungselement zum Erfassen einer Benutzertätigung auf. Das Betätigungselement kann beispielsweise eine Taste sein. Des Weiteren ist eine Aktoreinrichtung bereitgestellt, durch welche das Betätigungselement bewegt werden kann, wobei die Aktoreinrichtung hierzu einen Elektromagneten und einen Dauermagneten aufweist. Schließlich ist eine Steuereinrichtung bereitgestellt, die in Abhängigkeit von einem Betätigungssignal den Elektromagneten mit einem Strom beaufschlagt, um hierdurch das Betätigungselement aus einer Ruhestellung zu bewegen. Zu der Erfindung gehören auch ein Kraftfahrzeug mit der erfindungsgemäßen Bedienvorrichtung sowie ein Verfahren zum Betreiben einer Bedienvorrichtung.

Eine Bedienvorrichtung mit den beschriebenen Merkmalen ist aus der US 2011/0037546 A1 bekannt. Diese Bedienvorrichtung weist als Betätigungselement eine Platte auf, die auf zwei Aktoreinrichtungen gelagert ist, welche jeweils Dauermagneten sowie eine elektrische Spule als Elektromagneten aufweisen. Mit der Aktoreinrichtung kann die Platte aus einer Ruhestellung heraus bewegt werden. In der Ruhestellung wird die Platte gehalten, weil sie zwischen zwei elastischen Bereichen, einen Abdichtbereich und einen Auflagebereich, eingespannt ist.

Nachteilig bei der bekannten Bedienvorrichtung ist, dass die Platte nach dem Auslenken durch die Aktoreinrichtung dazu neigt, um die Ruhestellung herum zu schwingen, nachdem die Aktoreinrichtung deaktiviert worden ist. Grund dafür ist die federnde Lagerung der Platte zwischen den elastischen Elementen. Hierdurch wird das vom Benutzer beim Betätigen der Platte fühlbare haptische Feedback (Rückmeldung) als unpräzise oder schwammige oder langsam ausklingende Vibration wahrgenommen.

Wünschenswert wäre dagegen eine Bedienvorrichtung, bei welcher ein Betätigungselement, beispielsweise eine Taste, eine zeitlich begrenzte, von einem Benutzer deutlich wahrnehmbare einmalige Bewegung ausführt, beispielsweise eine Klickbewegung oder eine Erschütterung oder einen Sprung. Aus der DE 10 2011 089 400 A1 ist eine Bedienvorrichtung für ein Kraftfahrzeug bekannt, bei welcher eine Bewegung eines Betätigungselements mittels einer magnetorheologischer Flüssigkeit gebremst wird, wobei bei der Flüssigkeit bei der Viskosität über ein externes Magnetfeld steuerbar ist. Mittels eines Dauermagneten wird hierbei die Bewegung gesperrt und durch Aufheben des Magnetfelds des Dauermagneten mittels eines Elektromagneten wird das Betätigungselement bewegbar.

Aus der DE 10 2011 079 863 A1 ist ein Dreh-Drück-Steller bekannt, dessen räumliche Auslenkung durch eine Benutzerbetätigung in der Weise erfasst wird, dass an dem Dreh-Drück-Steller ein Dauermagnet angeordnet ist und Hall-Sensoren einer neben dem Steller angeordneten Leiterplatine eine Veränderung des Magnetfelds des Dauermagneten erfassen.

US 5 790 108 A betrifft ein elektromagnetisches System zum Aufbringen einer Kraftrückkopplung auf die bewegliche Plattform einer Steuerung.

EP 0 518 648 A2 betrifft ein Verfahren zum Einstellen der Tastenberührung einer Tastatur.

Der Erfindung liegt die Aufgabe zu Grunde, bei einer Bedienvorrichtung eines Kraftfahrzeugs eine zeitlich deutlich abgegrenzte oder zeitlich deutlich begrenzte haptische Rückmeldung für einen Benutzer zu erzeugen.

Die Aufgabe wird durch die Gegenstände der unabhängigen Patentansprüche gelöst. Vorteilhafte Weiterbildungen der Erfindung sind durch die abhängigen Patentansprüche gegeben.

Durch die Erfindung ist eine Bedienvorrichtung für ein Kraftfahrzeug bereitgestellt. Die Bedienvorrichtung weist in der beschriebenen Weise ein Betätigungselement auf, das zum Erfassen einer Benutzerbetätigung bereitgestellt ist. Das Betätigungselement kann beispielsweise als Taste ausgestaltet sein. Das Betätigungselement ist bezüglich eines Gehäuses der Bedienvorrichtung bewegbar gelagert. Zum Erzeugen einer haptischen Rückmeldung ist eine Aktoreinrichtung bereitgestellt, die einen Elektromagneten als erstes Magnetelement und einen Dauermagneten als zweites Magnetelement aufweist, wobei eines der beiden Magnetelemente bezüglich des Betätigungselements und das andere der beiden Magnetelemente bezüglich des Gehäuses fest gelagert ist. Eine Steuereinrichtung ist derart eingerichtet, dass sie in Abhängigkeit von einem vorbestimmten Betätigungssignal den Elektromagneten mit einem ersten elektrischen Strom beaufschlagt, durch welchen der Elektromagnet den Dauermagneten mit einer ersten Magnetkraft beaufschlagt, welche das Betätigungselement aus einer Ruhestellung auslenkt. Die Steuereinrichtung kann beispielsweise auf der Grundlage eines Mikrocontrollers oder einer Prozessoreinrichtung realisiert sein. Das Betätigungselement kann beispielsweise in Abhängigkeit von einer Betätigung des Betätigungselements erzeugt werden. Durch beaufschlagen des Elektromagneten mit dem ersten Strom wird also das Betätigungselement aktiv durch die Aktoreinrichtung bewegt. Dies fühlt der Benutzer als haptische Rückmeldung.

Um diese haptische Rückmeldung nun klar zeitlich abzugrenzen, wird erfindungsgemäß ein mechanisches Anschlagelement bereitgestellt und eine elastisch verformbar ausgestaltete Rückstelleinrichtung drückt das Betätigungselement gegen das Anschlagelement in die Ruhestellung. Die Bedienvorrichtung kann auch mehrere Anschlagselemente aufweisen. Im Folgenden ist nur auf ein Anschlagselement Bezug genommen, da die Erfindung sich prinzipiell mit einem einzelnen Anschlagselement realisieren lässt. Die Rückstelleinrichtung kann beispielsweise als eine Feder, beispielsweise eine Spiralfeder oder Blattfeder, ausgestaltet sein. Durch die Rückstelleinrichtung wird das Betätigungselement permanent oder dauerhaft mit einer Rückstellkraft beaufschlagt, welche das Betätigungselement in die Ruhestellung drückt. Das Rückstellelement kann auch in der Weise angeordnet sein, dass es das Betätigungselement in die Ruhestellung zieht. Das Anschlagelement kann beispielsweise ein Steg oder ein Vorsprung am Gehäuse sein. Das Anschlagelement ist insbesondere aus einem starren, d.h. unelastischen Material, z.B. aus einem Kunststoff oder einem Metall. Dies unterdrückt ein Nachschwingen.

Durch die Erfindung ergibt sich der Vorteil, dass nach Deaktivieren des ersten Stroms, wenn die Aktoreinrichtung also keine Magnetkraft mehr zwischen dem Dauermagneten und dem Elektromagneten erzeugt, das ausgelenkte Betätigungselement durch die Rückstelleinrichtung wegen der Rückstellkraft gegen das Anschlagelement gedrückt oder gezogen wird. Sobald das Anschlagelement erreicht ist, das heißt das Betätigungselement das Anschlagelement in der Ruhestellung berührt, ist die Auslenkung, das heißt die Bewegung des Betätigungselements, beendet. Es kann kein Ausschwingen um die Ruhestellung herum erfolgen. Somit endet die haptische Rückmeldung abrupt und/oder prägnant und/oder mit der Berührung des Anschlagselements durch das Betätigungselement. Das Auslenken des Betätigungselements weg aus der Ruhestellung mittels der Aktoreinrichtung und das anschließende Zurückbewegen des Betätigungselements gegen das Anschlagelement wird von dem Benutzer als Klicken empfunden, also beispielsweise als Klicken einer Taste.

Zu der Erfindung gehören auch Weiterbildungen, durch deren Merkmale sich zusätzliche Vorteile ergeben.

Gemäß der Erfindung ist die Steuereinrichtung derart eingerichtet, dass sie nach dem ersten Strom, nachdem also der Elektromagnet mit dem ersten Strom beaufschlagt worden ist, den Elektromagneten mit einem elektrischen zweiten Strom beaufschlagt, durch welche der Elektromagnet den Dauermagneten mit einer der ersten Magnetkraft entgegengesetzten zweiten Magnetkraft beaufschlagt. Beispielsweise wird also der Strom umgepolt, um vom ersten Strom zum zweiten Strom umzuschalten. Durch Beaufschlagen des Dauermagneten mit der zweiten Magnetkraft wird das ausgelenkte Betätigungselement in die Ruhestellung zurück gegen das Anschlagelement gedrückt oder gezogen. Mit anderen Worten wird die Rückstelleinrichtung durch den Elektromagneten darin unterstützt, das Betätigungselement in die Ruhestellung zurückzubewegen und dort gegen das Anschlagelement zu drücken oder zu ziehen. Hierdurch kann eine für den Benutzer deutlich fühlbare einmalige Auslenkung, das heißt ein Stoß oder eine Erschütterung, in dem Betätigungselement verursacht oder erzeugt werden.

Gemäß einer Weiterbildung ist die Steuereinrichtung hierbei dazu ausgelegt, dass sie den zweiten Strom innerhalb einer vorbestimmten Zeitdauer nach Beginn des Auslenkens des Betätigungselements aus der Ruhestellung erzeugt. Mit anderen Worten dauert die Auslenkung ab Beginn des Auslenkens, das heißt ab Beginn der Bewegung weg aus der Ruhestellung, eine vorbestimmte Zeitdauer. Diese Zeitdauer ist kleiner als 200 ms. Hierdurch ergibt sich ein prägnantes mechanisches Klicken, das der Benutzer beispielsweise mit dem Finger an dem Betätigungselement fühlen kann. Eine andere Bezeichnung hierfür ist auch Knackfroscheffekt.

Die Erfindung sieht vor, dass die Steuereinrichtung dazu ausgelegt ist, dass sie das Betätigungselement mittels der zweiten Magnetkraft in der Ruhestellung für eine vorbestimmte Zeitdauer hält. Die Zeitdauer kann beispielsweise in einem Bereich von 10 ms bis 500 ms liegen. Durch diese Weiterbildung ergibt sich in vorteilhafter Weise eine Prellunterdrückung. Mit anderen Worten ist verhindert, dass das Betätigungselement an dem Anschlagelement abprallet und noch einmal eine vom Benutzer fühlbare Prellbewegung ausführt.

Gemäß einer Weiterbildung weist das Betätigungselement nicht nur eine einzelne Taste auf, sondern mehrere Tastenfelder. Mit anderen Worten sind an dem Betätigungselement mehrere voneinander unterscheidbare Tasten bereitgestellt. Ein Tastenfeld kann z.B. durch eine Tastenkappe oder eine Tastenattrappe gebildet sein, das an dem Betätigungselement befestigt ist. Eine Sensoreinrichtung zum Erfassen der Benutzerbetätigung ist dazu ausgelegt, zu detektieren, welche der Tasten ein Benutzer berührt. Hierzu kann in jedem Tastenfeld beispielsweise ein kapazitiver Sensor oder ein Mikroschalter bereitgestellt sein. Durch diese Weiterbildung ergibt sich der Vorteil, dass mit einer einzelnen Aktoreinrichtung (Dauermagnet und Elektromagnet) die beschriebene haptische Rückmeldung für mehrere Tasten oder Tastenfelder realisiert ist. Um zu unterscheiden, welches der Tastenfelder durch den Benutzer bei der Benutzerbetätigung bedient oder gedrückt oder berührt wurde, dient dann die beschriebene Sensoreinrichtung, die technisch insbesondere weit aufwandsärmer bereitstellbar ist, als eine eigene Aktoreinrichtung pro Taste.

Gemäß einer Weiterbildung ist ein Kraftsensor bereitgestellt, welcher ein Kraftsignal erzeugt, das mit einer Bedienkraft korreliert, mit welcher das Betätigungselement durch die Benutzerbetätigung beaufschlagt ist. Der Kraftsensor kann beispielsweise auf der Grundlage eines elektrischen Widerstands gebildet sein, dessen Widerstandswert sich in Abhängigkeit von der Bedienkraft ändert. Die Steuereinrichtung ist in diesem Fall derart eingerichtet, dass sie das Betätigungssignal erzeugt, falls das Kraftsignal eine Bedienkraft größer als ein vorbestimmter Schwellenwert signalisiert. Der Schwellenwert kann beispielsweise in einem Bereich zwischen zwei Newton und sechs Newton liegen. Durch diese Weiterbildung ergibt sich der Vorteil, dass nicht schon eine einfache Berührung oder Annäherung an das Betätigungselement die beschriebene Auslenkung des Betätigungselements durch die Aktoreinrichtung verursacht. Vielmehr muss der Benutzer zunächst mindestens die Bedienkraft aufbringen, die größer als der Schwellenwert ist, damit auch tatsächlich eine Benutzerbetätigung registriert oder detektiert wird. Hierdurch ist eine versehentliche Betätigung der Bedienvorrichtung wirkungsvoll vermieden.

Gemäß einer Weiterbildung ist die Steuereinrichtung derart eingerichtet, dass sie einen zeitlichen Stromstärkeverlauf des ersten Stromes und/oder des zweiten Stromes mit einem vorbestimmten Haptiksignal moduliert. Mit anderen Worten wird dem Betätigungselement während der Auslenkbewegung des Betätigungselements aus der Ruhestellung und/oder zurück in die Ruhestellung ein zusätzliches Bewegungssignal aufgeprägt, das durch das Haptiksignal bestimmt ist. Beispielsweise kann eine Vibration aufmoduliert werden. Hierdurch ergibt sich der Vorteil, dass dem Benutzer unterschiedliche haptische Signale mittels unterschiedlicher Haptiksignale vermittelt werden können.

Wie bereits ausgeführt, gehört zu der Erfindung auch ein Kraftfahrzeug. Bei dem erfindungsgemäßen Kraftfahrzeug ist zumindest ein Gerät des Kraftfahrzeugs mit einer Bedienvorrichtung gekoppelt, welche eine Ausführungsform der erfindungsgemäßen Vorrichtung darstellt. Bei dem zumindest einen Gerät kann es sich beispielsweise um ein Infotainmentsystem (Informations-Unterhaltungssystem) und/oder eine Klimaanlage und/oder eine Fahrwerksteuerung und/oder ein Telematiksystem handeln. Die Bedienvorrichtung ist dazu ausgelegt, in Abhängigkeit von einer Benutzerbetätigung an der Bedienvorrichtung ein Steuersignal an das zumindest eine Gerät auszusenden. Hierdurch kann also ein Benutzer durch Betätigen der Bedienvorrichtung (Benutzerbetätigung) mittels der Bedienvorrichtung das zumindest eine Gerät bedienen. Die Benutzerbetätigung wird hierbei in der beschriebenen Weise an dem Betätigungselement durchgeführt. In Abhängigkeit von einem Signal einer Sensoreinrichtung und/oder eines Drucksensors kann dabei das Betätigungssignal zum Auslösen der haptischen Rückmeldung erzeugt werden. In an sich bekannter Weise kann zusammen mit dem Betätigungssignal auch ein Steuersignal erzeugt werden, durch welches zumindest ein Gerät des Kraftfahrzeugs gesteuert wird. Das Betätigungssignal kann auch als eine externes Signal an die Bedienvorrichtung übertragen werden.

Das erfindungsgemäße Kraftfahrzeug ist bevorzugt als Kraftwagen, insbesondere als Personenkraftwagen ausgestaltet.

Schließlich gehört zu der Erfindung auch ein Verfahren zum Betreiben einer Bedienvorrichtung. Durch das erfindungsgemäße Verfahren sind die wesentlichen Schritte einer bevorzugten Ausführungsform der Erfindung zusammengefasst. Das Verfahren geht aus von einem Betätigungselement, das bezüglich eines Gehäuses der Bedienvorrichtung bewegbar gelagert ist. Im unbetätigten Zustand weist das Betätigungselement eine Ruhestellung auf, in welcher es durch ein mechanisches Anschlagelement blockiert wird. Hierbei kann das Betätigungselement durch eine Rückstelleinrichtung gegen das Anschlagelement gedrückt oder gezogen werden.

Das Betätigungselement wird durch eine Benutzerbetätigung bewegt, idem der Benutzer z.B. das Betätigungselement berührt oder drückt. Eine Erfassung der Benutzerbetätigung kann beispielsweise auf Grundlage der beschriebenen Sensoreinrichtung (kapazitiver Sensor, Mikroschalter) erfolgen. Eine Steuereinrichtung beaufschlagt in Abhängigkeit von einem vorbestimmten Betätigungssignal mittels eines Elektromagneten einer Aktoreinrichtung einen Dauermagneten der Aktoreinrichtung mit einer ersten Magnetkraft. Dies erfolgt in der beschriebenen Weise. Das Betätigungssignal kann beispielsweise in Abhängigkeit von dem Sensorsignal der beschriebenen Sensoreinrichtung bei Erfassen der Benutzerbetätigung erzeugt werden. Die erste Magnetkraft lenkt in der beschriebenen Weise das Betätigungselement aus der Ruhestellung aus, d.h. das Betätigungselement führt eine Auslenkbewegung aus. Um nun diese aktive Auslenkung zu einem zeitlich prägnanten oder zeitlich klar abgegrenzten haptischen Feedback oder einer haptischen Rückmeldung zu formen, ist bei den erfindungsgemäßen Verfahren vorgesehen, dass nach Erzeugen der ersten Magnetkraft anschließend mittels des Elektromagneten der Dauermagnet mit einer der ersten Magnetkraft entgegengesetzten zweiten Magnetkraft beaufschlagt wird, welche das Betätigungselement gegen das Anschlagelement in die Ruhestellung zurückdrückt oder -zieht und zum Bereitstellen einer Prellunterdrückung, die verhindert, dass das Betätigungselement an dem Anschlagelement abprallt und noch einmal eine vom Benutzer fühlbare Prellbewegung ausführt, das Betätigungselement mittels der zweiten Magnetkraft in der Ruhestellung für eine vorbestimmte Zeitdauer hält. Mit Anschlagen an dem Anschlagelement beendet das Betätigungselement sprunghaft oder stoßhaft seine Auslenkbewegung, so dass die Auslenkung schlagartig beendet ist. Es ist insbesondere ein Ausschwingen des Betätigungselements um die Ruhestellung herum vermieden.

Zu der Erfindung gehören auch Weiterbildungen des Verfahrens, welche Merkmale aufweisen, die bereits im Zusammenhang mit den Weiterbildungen der erfindungsgemäßen Bedienvorrichtung beschrieben worden sind. Aus diesem Grund sind die entsprechenden Weiterbildungen des erfindungsgemäßen Verfahrens hier noch einmal beschrieben.

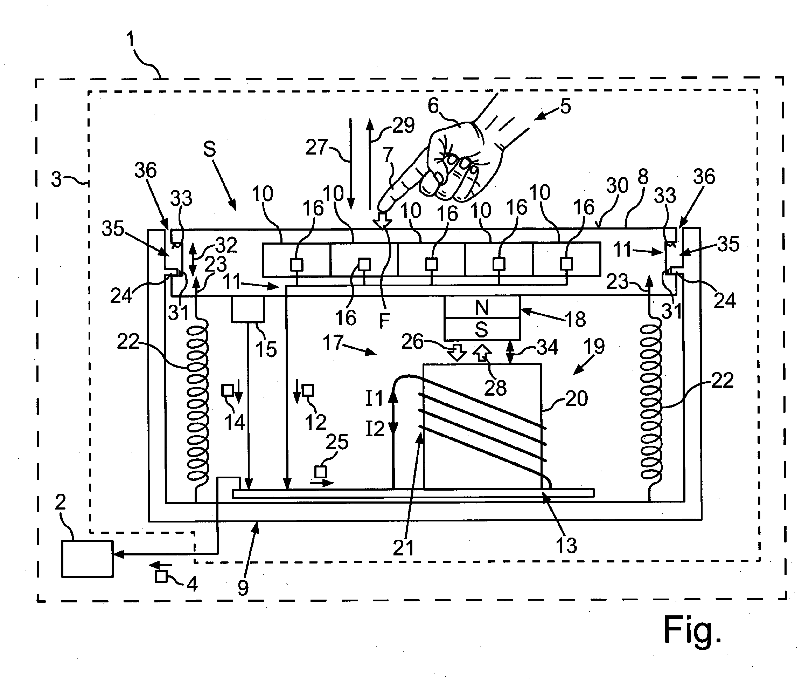

Im Folgenden ist ein Ausführungsbeispiel der Erfindung beschrieben. Hierzu zeigt die einzige Figur (Fig.) eine schematische Darstellung einer Ausführungsform des erfindungsgemäßen Kraftfahrzeugs.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

Die Figur zeigt ein Kraftfahrzeug 1, bei dem es sich beispielsweise um einen Kraftwagens, insbesondere einen Personenkraftwagen, handeln kann. Dargestellt sind ein Gerät 2 und eine Bedienvorrichtung 3 für das Gerät 2. Die Bedienvorrichtung 3 ist mit dem Gerät 2 gekoppelt, beispielsweise über einen CAN-Bus (CAN - Controller Area Network). Das Gerät 2 kann beispielsweise ein Infotainmentsystem, eine Klimaanlage, eine Telefonanlage, eine Fahrwerksteuerung sein. Die Bedienvorrichtung 3 kann auch mit mehreren Geräten gekoppelt sein. Die Bedienvorrichtung 3 erzeugt zum Steuern des Gerätes 2 ein Steuersignal 4 in Abhängigkeit von einer Benutzerbetätigung der Bedienvorrichtung 3 durch einen Benutzer 5, von dem in der Figur nur eine Hand 6 mit einem Finger 7 dargestellt ist. Zum Betätigen der Bedienvorrichtung 3 weist die Bedienvorrichtung ein Betätigungselement 8 auf, das beweglich oder bewegbar in einem Gehäuse 9 der Bedienvorrichtung 3 angeordnet ist. An dem Betätigungselement 8 sind ein Tastenfeld oder mehrere Tastenfelder 10 angeordnet, von denen der Benutzer 5 mit dem Finger 7 ein Tastenfeld 10 drückt. Eine Sensorienrichtung 11 erfasst, welches Tastefeld 10 der Benutzer 5 berührt oder gedrückt hat und signalisiert durch ein Sensorsignal 12 das betätigte oder bediente Tastenfeld 10. Die Sensoreinrichtung 11 kann zum Erfassen einer Berührung und/oder Annäherung des Benutzers 5 an eines der Tastenfelder 10 für jedes der Tastenfelder 10 einen Sensor 16 aufweisen, der beispielsweise ein kapazitiver Näherungssensor sein kann.

Eine Steuereinrichtung 13 erzeugt in Abhängigkeit von dem Sensorsignal 12 das Steuersignal 4. Die Steuereinrichtung 13 kann beispielsweise auf der Grundlage einer Leiterplatte gebildet sein, mittels welcher eine elektronische Schaltung realisiert ist. Es kann zusätzlich vorgesehen sein, dass die Steuereinrichtung 13 ein Kraftsignal 14 des Kraftsensors 15 empfängt, durch welches signalisiert ist, mit welcher Bedienkraft F oder Betätigungskraft der Benutzer 5 beispielsweise mit dem Finger 7 auf das Betätigungselement 8 drückt. Es kann vorgesehen sein, dass das Steuersignal 4 durch die Steuereinrichtung 13 nur erzeugt wird, falls die Bedienkraft F gemäß dem Kraftsignal 14 größer als ein vorbestimmter Schwellenwert ist. Der Kraftsensor 15 kann beispielsweise auf der Grundlage eines kraftveränderlichen Widerstandes gebildet sein oder eine Blattfeder aufweisen, die bei einer Bedienkraft F größer als der Schwellenwert einen Kontakt schließt oder öffnet.

Beim Bedienen eines der Tastenfelder 10 spürt der Benutzer mit dem Finger 7 eine haptische Rückmeldung. Hierbei spürt der Benutzer, dass das Tastenfeld 10 eine Klickbewegung ausführt, die zeitlich prägnant und mit einem deutlicht spürbaren Bewegungshub ausgeführt wird.

Hierzu weist die Bedienvorrichtung 3 eine Aktoreinrichtung 17 auf, die einen Permanentmagneten oder Dauermagneten 18 und einen Elektromagneten 19 umfasst. Der Elektromagnet 19 kann beispielsweise auf der Grundlage eines weichmagnetischen Eisenkerns 20 und einer elektrischen Spule 21 gebildet sein. Der Elektromagnet 19 kann auch ohne den Eisenkern 20 bereitgestellt sein. Insbesondere kann die elektrische Spule 21 auch aus Leiterbahnen der Leiterplatte der Steuereinrichtung 13 gebildet sein, das heißt als Flachspule ausgestaltet sein.

Der Dauermagnet 18 ist in dem gezeigten Beispiel an dem Betätigungselement 8 befestigt. Der Elektromagnet 19 ist in dem gezeigten Beispiel beispielsweise über die Steuereinrichtung 13 mit dem Gehäuse 9 fest verbunden. Die Positionen können auch getauscht sein, so dass der Elektromagnet 19 am Betätigungselement 8 und der Dauermagnet 18 mit dem Gehäuse 9 fest verbunden ist.

Die Bedienvorrichtung 3 weist des Weiteren eine Rückstelleinrichtung 22 auf, welche das Betätigungselement 8 mit einer Rückstellkraft 23 beaufschlagt, durch welche sie das Betätigungselement 8 in einer Ruhestellung S hält, falls der Elektromagnet 19 inaktiv ist, das heißt unbestromt oder ausgeschaltet ist. Die Ruhestellung S oder Ruhelage ist definiert durch ein Anschlagelement 24, gegen welches das Betätigungselement 8 durch die Rückstelleinrichtung 22 gedrückt wird. In dem in der Figur gezeigten Beispiel sind zwei Anschlagselemente 24 dargestellt. Im Folgenden wird bei der Erläuterung stets nur auf ein einzelnes Anschlagselement 34 und in diesem Zusammenhang auch auf weitere mehrfach bereitgestellte Elemente lediglich im Singular Bezug genommen, da deren Funktion jeweils identisch ist.

Die Rückstelleinrichtung 22 kann beispielsweise eine oder mehrere Spiralfedern aufweisen, wie dies in der Figur dargestellt ist. Das Anschlagelement 24 kann beispielsweise durch einen Stab oder eine Nocke oder einen Steg gebildet sein. Das Anschlagelement 24 ist insbesondere aus einem starren, nicht-federnden Material. Das Betätigungselement 8 kann beispielsweise aus einem Kunststoff gefertigt sein, wodurch es besonders leicht ist und daher mit wenig elektrischer Leistung des Elektromagneten 19 bewegt werden kann.

Mit dem Erzeugen des Steuersignals 4 erzeugt die Steuereinrichtung 13 ein Betätigungssignal 25, durch welches das haptische Feedback ausgelöst wird, welches den Benutzer 5 am Finger 7 signalisiert, dass er das Tastenfeld 10 erfolgreich betätigt hat. In Abhängigkeit von dem Betätigungssignal 25 wird der Elektromagnet 19 mit einem ersten Strom I1 beaufschlagt, das heißt die Spule 21 wird mit dem ersten Strom I1 bestromt oder beaufschlagt oder beschaltet. Hierdurch erzeugt der Dauermagnet 18 eine magnetische Anziehungskraft 26 auf den Dauermagneten 18.

Hierdurch wird der Dauermagnet 18 von dem Elektromagneten 19 angezogen und mit ihm das Betätigungselement 8 in eine Auslenkrichtung 27 aus der Ruhestellung S heraus bewegt. Anschließend wird der Elektromagnet 19 durch die Steuereinrichtung 13 mit einem zweiten Strom I2 beaufschlagt oder bestromt. Hierdurch erzeugt der Elektromagnet 19 eine Abstoßungskraft 28 auf den Dauermagneten 18. Hierdurch wird das Betätigungselement 8 mit der Abstoßungskraft 28 zusätzlich zur Rückstellkraft 23 zurück in die Ruhestellung S bewegt. Mit anderen Worten findet eine Rückbewegung 29 in die Ruhestellung S statt.

Somit wird bei der Bedienvorrichtung 3 das Betätigungselement 8 in zwei entgegengesetzte Richtungen aktiv angeregt oder bewegt oder beschleunigt. Hierdurch ergibt sich eine bidirektionale aktive Haptik oder Aktorik durch die Aktoreinrichtung 17. Damit lässt sich eine Bedienoberfläche 30, die durch den Benutzer 5 berührt wird, aktiv beschleunigen und prägnant wieder abbremsen, das heißt insbesondere zum Stillstand bringen. Ein unerwünschtes Nachschwingen ist hierdurch vermieden. Indem der Dauermagnet 19 mit einem Permanentmagneten 18 kombiniert ist, ist es möglich, die Aktoreinrichtung 17 gegenzutakten, das heißt die Stromrichtung des Stromes umzukehren, um die beschleunigte Bedienoberfläche 30 wieder abzubremsen.

Hierbei sind durch Modulieren des ersten Stroms I1 und des zweiten Stroms I2 verschiedene Ansteuerimpulse möglich. Insbesondere ist hierbei die Bedienoberfläche 30 in zwei Richtungen bewegbar, nämlich aus der Ruhestellung S heraus und aktiv zur Ruhestellung S zurück.

Die Bedienoberfläche 30, das heißt das Betätigungselement 8, wird dabei zunächst durch die Rückstelleinrichtung 22 in die Nullstellung oder Nulllage oder Ruhestellung S gedrückt. An dem Betätigungselement 8 ist des Weiteren in dem Beispiel der Permanentmagnet 18 befestigt, beispielsweise an einer der Bedienoberfläche 30 gegenüberliegenden Rückseite des Betätigungselements 8. Der Permanentmagnet 18 ist dem Elektromagneten 19 gegenüber angeordnet. Der Elektromagnet 19 ist mit dem Gehäuse 9 verbunden und wird von einer Steuerelektronik der Steuereinrichtung 13 angesteuert. Wird nun der Elektromagnet angesteuert, kann er das Betätigungselement 8 auslenken und/oder beschleunigen und dann durch Wechseln der Stromrichtung mittels des zweiten Stroms I2 durch die resultierende Magnetfeldänderung wieder in die Ruhestellung S drücken (Gegentaktung). Der Benutzer 5 empfindet eine prägnante und/oder hochwertige Haptik beim Betätigen des Betätigungselements 8, also beim Betätigen einer der Tastenfelder 10. Einem unerwünschten Nachschwingen der Oberfläche kann hierdurch entgegengewirkt werden.

In der Ruhestellung S liegt das Betätigungselement 8 beispielsweise an einer Anlagefläche 31 des Betätigungselements 8 an dem Anschlagselement 24 an. Ein Hub- oder Auslenkungsweg 32 des Betätigungselements 8 bei der Auslenkbewegung 27 und der Rückstellbewegung 29 kann durch eine zweite Anlagefläche 33 begrenzt sein. Insbesondere ist der Auslenkungsweg 32 kleiner als ein Abstand 34 des Dauermagneten 18 vom Elektromagneten 19. Hierdurch wird ein Anhaften des Dauermagneten 18 am Elektromagneten 19 vermiedne. Die beiden Anlageflächen 31, 33 können durch einen Hinterschnitt 35 im Betätigungselement 8 gebildet sein. Hierdurch ergibt sich der Vorteil, dass ein Spaltmaß eines Spaltes 36 zwischen dem Betätigungselement 8 und dem Gehäuse 9 besonders klein eingestellt werden kann, insbesondere kleiner als 1 Millimeter. Bei dem Spalt 36 handelt es sich um den Sichtspalt, der vom Benutzer 5 vom Kraftfahrzeuginnenraum aus gesehen werden kann. Durch ein geringes Spaltmaß des Spaltes 36 ist auch verhindert, dass Gegenstände in das Gehäuse 9 fallen können.

Insgesamt zeigt das Beispiel, wie durch die Erfindung ein Bedienelement mit aktiver Haptik und Gegentaktung am Aktor bereitgestellt werden kann.

## Patentansprüche

1. Bedienvorrichtung (3) für ein Kraftfahrzeug (1), aufweisend:
- ein Betätigungselement (8), das bezüglich eines Gehäuses (9) der Bedienvorrichtung (3) bewegbar gelagert ist,
- eine Aktoreinrichtung (17), die einen Elektromagneten (19) als erstes Magnetelement und einen Dauermagneten (18) als zweites Magnetelement aufweist, wobei eines der beiden Magnetelemente bezüglich des Betätigungselements (8) und das andere der beiden Magnetelemente bezüglich des Gehäuses (9) fest gelagert ist, und
- eine Steuereinrichtung (13), die derart eingerichtet ist, dass sie in Abhängigkeit von einem vorbestimmten Betätigungssignal (25) den Elektromagneten (19) mit einem elektrischen ersten Strom (I1) beaufschlagt, durch welchen der Elektromagnet (19) den Dauermagneten (18) mit einer ersten Magnetkraft (26) beaufschlagt, welche das Betätigungselement (8) aus einer Ruhestellung (S) auslenkt, wobei zumindest ein mechanisches Anschlagelement (24) bereitgestellt ist und eine elastisch verformbar ausgestaltete Rückstelleinrichtung (22) das Betätigungselement (8) gegen das Anschlagelement (24) mit einer Rückstellkraft (23) zur Ruhestellung (S) drückt oder zieht,
**dadurch gekennzeichnet, dass** die Steuereinrichtung (13) derart eingerichtet ist, dass sie nach dem ersten Strom (I1) den Elektromagneten (19) mit einem elektrischen zweiten Strom (I2) beaufschlagt, durch welchen der Elektromagnet (19) den Dauermagneten (18) mit einer der ersten Magnetkraft (26) entgegen gesetzten zweiten Magnetkraft (28) beaufschlagt und hierdurch das ausgelenkte Betätigungselement (8) in die Ruhestellung (S) zurück gegen das zumindest eine Anschlagelement (24) drückt oder zieht und zum Bereitstellen einer Prellunterdrückung, die verhindert, dass das Betätigungselement (8) an dem Anschlagelement (24) abprallt und noch einmal eine vom Benutzer fühlbare Prellbewegung ausführt, das Betätigungselement (8) mittels der zweiten Magnetkraft (28) in der Ruhestellung (S) für eine vorbestimmte Zeitdauer hält.

2. Bedienvorrichtung (3) nach Anspruch 1, wobei die Steuereinrichtung (13) dazu ausgelegt ist, dass sie den zweiten Strom (I2) innerhalb einer vorbestimmten Zeitdauer nach Beginn des Auslenkens des Betätigungselements (8) aus der Ruhestellung (S) erzeugt, wobei die Zeitdauer kleiner als 200 Millisekunden ist.

3. Bedienvorrichtung (3) nach einem der vorhergehenden Ansprüche, wobei das Betätigungselement (8) mehrere Tastenfelder (10) aufweist und eine Sensoreinrichtung (11) zum Erfassen der Benutzerbetätigung dazu ausgelegt ist zu detektieren, welches der Tastenfelder (10) der Benutzer (5) berührt.

4. Bedienvorrichtung (3) nach einem der vorhergehenden Ansprüche, wobei ein Kraftsensor (15) bereitgestellt ist, welcher ein Kraftsignal (14) erzeugt, das mit einer Bedienkraft (F), mit welcher das Betätigungselement (8) bei der Benutzerbetätigung beaufschlagt ist, korreliert ist, und wobei die Steuereinrichtung (13) derart eingerichtet ist, dass sie das Betätigungssignal (25) erzeugt, falls das Kraftsignal (14) eine Bedienkraft (F) größer als ein vorbestimmter Schwellenwert signalisiert.

5. Bedienvorrichtung (3) nach einem der vorhergehenden Ansprüche, wobei die Steuereinrichtung (13) derart eingerichtet ist, dass sie einen zeitlichen Stromstärkeverlauf des ersten Stromes (I1) und/oder des zweiten Stromes (I2) mit einem vorbestimmten Haptiksignal moduliert.

6. Kraftfahrzeug (1) mit zumindest einem Gerät (2) und mit einer Bedienvorrichtung (3) nach einem der vorhergehenden Ansprüche, wobei die Bedienvorrichtung (3) mit dem zumindest eine Gerät (2) gekoppelt ist und dazu ausgelegt ist, in Abhängigkeit von einer Benutzerbetätigung an der Bedienvorrichtung (3) ein Steuersignal (4) an das zumindest eine Gerät (2) auszusenden.

7. Verfahren zum Betreiben einer Bedienvorrichtung (3), wobei ein Betätigungselement (8), das bezüglich eines Gehäuses (9) der Bedienvorrichtung (3) bewegbar gelagert ist, eine Benutzerbetätigung erfasst und eine Steuereinrichtung (13) in Abhängigkeit von einem vorbestimmten Betätigungssignal (25) mittels eines Elektromagneten (19) einer Aktoreinrichtung (17) einen Dauermagneten (18) der Aktoreinrichtung (17) mit einer ersten Magnetkraft (26) beaufschlagt, welche das Betätigungselement (8) aus einer durch zumindest ein mechanisches Anschlagelement (24) festgelegte Ruhestellung (S) auslenkt,
**dadurch gekennzeichnet, dass**
anschließend mittels des Elektromagneten (19) der Dauermagnet (18) mit einer der ersten Magnetkraft (26) entgegen gesetzten zweiten Magnetkraft (28) beaufschlagt wird, welche das aus der Ruhestellung (S) ausgelenkte Betätigungselement (8) in die Ruhestellung (S) zurück gegen das zumindest eine Anschlagelement (24) drückt oder zieht und zum Bereitstellen einer Prellunterdrückung, die verhindert, dass das Betätigungselement (8) an dem Anschlagelement (24) abprallt und noch einmal eine vom Benutzer fühlbare Prellbewegung ausführt, das Betätigungselement (8) mittels der zweiten Magnetkraft (28) in der Ruhestellung (S) für eine vorbestimmte Zeitdauer hält.

## Claims

1. Operating device (3) for a motor vehicle (1), comprising:
- an actuation element (8), which is movably mounted in relation to a housing (9) of the operating device (3),
- an actuator device (17) which has an electromagnet (19) as the first magnet element and a permanent magnet (18) as the second magnet element, wherein one of the two magnet elements is fixedly mounted in relation to the actuation element (8) and the other of the two magnet elements is fixedly mounted in relation to the housing (9), and
- a control device (13) configured such that it applies anelectric first current (I1) to the electromagnet (19) as a function of a predetermined actuation signal (25) by means of which the electromagnet (19) applies a first magnetic force (26) to the permanent magnet (18), which deflects the actuation element (8) from a rest position (S), wherein at least one mechanical stop element (24) is provided and an elastically deformably designed return device (22) presses or pulls the actuation element (8) against the stop element (24) with a return force (23) to the rest position (S), **characterised in that** the control device (13) is configured such that it applies an electric second current (12) to the electromagnet (19) after the first current (I1), by means of which the electromagnet (19) applies a second magnetic force (28) opposed to the first magnetic force (26) to the permanent magnet (18) and hereby presses or pulls the deflected actuation element (8) into the rest position (S) back against the at least one stop element (24) and, in order to provide a bounce suppression preventing the actuation element (8) rebounding on the stop element (24) and again performing a bounce movement noticeable to the user, holds the actuation element (8) by means of the second magnetic force (28) in the rest position (S) for a predetermined time.

2. Operating device (3) according to claim 1, wherein the control device (13) is designed such that it generates the second current (12) within a predetermined time after the actuation element (8) begins to deflect from the rest position (S), wherein the time is less than 200 milliseconds.

3. Operating device (3) according to any one of the preceding claims, wherein the actuation element (8) has a plurality of keypads (10) and a sensor device (11) for recording the user actuation designed to detect which of the keypads (10) the user (5) touches.

4. Operating device (3) according to any one of the preceding claims, wherein a force sensor (15) is provided which generates a force signal (14) which is correlated with an operating force (F), which is applied to the actuation element (8) in the case of the user actuation and wherein the control device (13) is configured such that it generates the actuation signal (25) if the force signal (14) signals an operating force (F) greater than a predetermined threshold value.

5. Operating device (3) according to any one of the preceding claims, wherein the control device (13) is configured such that it modulates a temporal current strength course of the first current (I1) and/or of the second current (I2) with a predetermined haptic signal.

6. Motor vehicle (1) with at least one device (2) and with an operating device (3) according to any one of the preceding claims, wherein the operating device (3) is coupled to the at least one device (2) and is designed to emit a control signal (4) to the at least one device (2) as a function of a user actuation at the operating device (3).

7. Method for operating an operating device (3), wherein an actuation element (8), which is movably mounted in relation to a housing (9) of the operating device (3), records a user actuation and a control device (13) applies a first magnetic force (26) to a permanent magnet (18) of the actuator device (17) as a function of a predetermined actuation signal (25) by means of an electromagnet (19) of an actuator device (17), said first magnetic force deflects the actuation element (8) from.a rest position (S) fixed by at least one mechanical stop element (24), **characterised in that** a second magnetic force (28) opposed to the first magnetic force (26) is subsequently applied to the permanent magnet (18) by means of the electromagnet (19), said second magnetic force presses or pulls the actuation element (8) deflected from the rest position (S) into the rest position (S) back against the at least one stop element (24) and, in order to provide a bounce suppression preventing the actuation element (8) rebounding on the stop element (24) and again performing a bounce movement noticeable to the user, holds the actuation element (8) by means of the second magnetic force (28) in the rest position (S) for a predetermined time.

## Revendications

1. Dispositif de fonctionnement (3) pour un véhicule automobile (1), présentant :
- un élément d'actionnement (8), qui est logé de manière mobile par rapport à un boîtier (9) du dispositif de fonctionnement (3),
- un appareil actionneur (17), qui présente un électroaimant (19) en tant que premier élément magnétique et un aimant permanent (18) en tant que deuxième élément magnétique, dans lequel un des deux éléments magnétiques est logé fixement par rapport à l'élément d'actionnement (8) et l'autre des deux éléments magnétiques est logé fixement par rapport au boîtier (9), et
- un appareil de commande (13), qui est aménagé de sorte qu'en fonction d'un signal d'actionnement prédéterminé (25), il alimente l'électroaimant (19) avec un premier courant électrique (I1), par lequel l'électroaimant (19) alimente l'aimant permanent (18) avec une première force magnétique (26), laquelle déplace l'élément d'actionnement (8) hors de la position de repos (S),
dans lequel
au moins un élément de butée mécanique (24) est mis à disposition et un dispositif de rappel configuré de manière élastiquement déformable (22) pousse ou tire l'élément d'actionnement (8) contre l'élément de butée (24) avec une force de rappel (23) vers la position de repos (S),
**caractérisé en ce que** l'appareil de commande (13) est aménagé de sorte qu'il alimente après le premier courant (I1) l'électroaimant (19) avec un deuxième courant électrique (I2), par lequel l'électroaimant (19) alimente l'aimant permanent (18) avec une deuxième force magnétique (28) opposée à la première force magnétique (26) et pousse ou tire ainsi l'élément d'actionnement (8) déplacé contre l'au moins un élément de butée (24) pour revenir dans la position de repos (S) et pour la mise à disposition d'une suppression de rebond qui empêche que l'élément d'actionnement (8) rebondisse sur l'élément de butée (24) et effectue encore une fois un mouvement de rebond perceptible par l'utilisateur, et qui maintient l'élément d'actionnement (8) dans la position de repos (S) pour une durée prédéterminée au moyen de la deuxième force magnétique (28).

2. Dispositif de fonctionnement (3) selon la revendication 1, dans lequel l'appareil de commande (13) est configuré de sorte qu'il génère le deuxième courant (I2) pendant une durée prédéterminée après le début du déplacement de l'élément d'actionnement (8) hors de la position de repos (S), dans lequel la durée est inférieure à 200 millisecondes.

3. Dispositif de fonctionnement (3) selon l'une quelconque des revendications précédentes, dans lequel l'élément d'actionnement (8) présente plusieurs claviers (10) et un dispositif de capteur (11) pour la détection de l'actionnement de l'utilisateur est conçu pour détecter lequel des claviers (10) est touché par l'utilisateur (5).

4. Dispositif de fonctionnement (3) selon l'une quelconque des revendications précédentes, dans lequel un capteur de force (15) est mis à disposition, lequel génère un signal de force (14), qui est corrélé avec une force d'actionnement (F), avec laquelle l'élément d'actionnement (8) est alimenté lors de l'actionnement de l'utilisateur, et dans lequel l'appareil de commande (13) est aménagé de sorte qu'il génère le signal d'actionnement (25), si le signal de force (14) signale une, force d'actionnement (F) supérieure à une valeur seuil prédéterminée.

5. Dispositif de fonctionnement (3) selon l'une quelconque des revendications précédentes, dans lequel l'appareil de commande (13) est aménagé de sorte qu'il module une courbe d'intensité de courant temporelle du premier courant (I1) et/ou du deuxième courant (I2) avec un signal haptique prédéterminé.

6. Véhicule automobile (1) avec au moins un appareil (2) et avec un dispositif de fonctionnement (3)selon l'une quelconque des revendications précédentes, dans lequel l'appareil de commande (3) est couplé avec l'au moins un appareil (2) et est conçu pour émettre un signal de commande (4) à l'au moins un appareil (2) en fonction d'un actionnement de l'utilisateur au niveau de l'appareil de commande (3).

7. Procédé de fonctionnement d'un dispositif de fonctionnement (3), dans lequel un élément d'actionnement (8), qui est logé de manière mobile par rapport à un boîtier (9) du dispositif de fonctionnement (3), détecte un actionnement de l'utilisateur et, en fonction d'un signal d'actionnement prédéterminé (25), au moyen d'un électroaimant (19) d'un appareil actionneur (17), un appareil de commande (13) alimente un aimant permanent (18) de l'appareil actionneur (17) avec une première force magnétique (26), laquelle déplace l'élément d'actionnement (8) hors d'une position de repos (S) fixée par au moins un élément de butée mécanique (24),
**caractérisé en ce que**
ensuite au moyen de l'électroaimant (19), l'aimant permanent (18) est alimenté avec une deuxième force magnétique (28) opposée à la première force magnétique (26), laquelle pousse ou tire l'élément d'actionnement (8) déplacé hors de la position de repos (S) contre l'au moins un élément de butée (24) pour revenir dans la position de repos (S) et pour la mise à disposition d'une suppression de rebond, qui empêche que l'élément d'actionnement (8) rebondisse sur l'élément de butée (24) et effectue encore une fois un mouvement de rebond perceptible par l'utilisateur, et qui maintient l'élément d'actionnement (8) dans la position de repos (S) pour une durée prédéterminée au moyen de la deuxième force magnétique (28).
